# EUROPEAN PATENT SPECIFICATION

(11) **EP 1 168 419 B1**
(45) Date of publication and mention of the grant of the patent: **01.10.2008**
(21) Application number: 00870135.1
(22) Date of filing: 19.06.2000
(51) Int. Cl.: H01L 21/00

(54) **Method and apparatus for localized liquid treatment of the surface of a substrate**
Verfahren und Vorrichtung zur lokalen Flüssigkeitsbehandlung von einer Substratoberfläche
Méthode et dispositif pour traiter localement à l'aide d'un liquide la surface d'un substrat

(43) Date of publication of application: 02.01.2002
(73) Proprietor: Interuniversitair Micro-Elektronica Centrum, 3001 Heverlee (BE)
(72) Inventor: Mertens, Paul, 2820 Bonheiden (BE); Meuris, Marc, 3140 Keerbergen (BE); Heyns, Marc, 3210 Linden (BE)
(74) Representative: Van Malderen, Joëlle

(56) References cited:
- US-A- 5 271 774
- US-A- 5 705 223
- US-A- 5 945 351
- PATENT ABSTRACTS OF JAPAN vol. 015, no. 102 (E-1043), 12 March 1991 (1991-03-12) -& JP 02 309638 A (FUJITSU LTD), 25 December 1990 (1990-12-25)
- PATENT ABSTRACTS OF JAPAN vol. 015, no. 046 (E-1029), 4 February 1991 (1991-02-04) -& JP 02 280330 A (MITSUBISHI ELECTRIC CORP), 16 November 1990 (1990-11-16)
- PATENT ABSTRACTS OF JAPAN vol. 2000, no. 03, 30 March 2000 (2000-03-30) -& JP 11 350169 A (CHEMITORONICS CO), 21 December 1999 (1999-12-21)
- PHILIP BALL: "Sunlight Soap"[Online] ISSN: 1744-7933 Retrieved from the Internet: URL:http://www.nature.com/news/1999/990701 /full/990701-10.html>
- [Online] retrieved from HTTP://EN.WIKIPEDIA.ORG/WIKI/MARANGONI-EFF ECT

## Description

### Field of the invention

The present invention is related to a method of localized liquid treatment of the surface of a substrate, like cleaning or etching. The invention is also related to an apparatus used to perform said treatment. Application of the invention is possible in a number of wet processing steps which are frequently used, e.g. in the fabrication of integrated circuits or liquid crystal displays.

### State of the art

In the fabrication of micro-electronic devices such as integrated circuits or liquid crystal displays, a substrate has to go through a number of fabrication steps, including wet etching, wet cleaning or rinsing.

In the documents US-A-5271774 and JP-A-07211686, methods are described to remove a liquid from the surface of a substrate by applying a gaseous tensio-active substance to the substrate, which, when mixed with the liquid, reduces the surface tension of the liquid, so that it can be easily removed from the surface by a centrifugal force, i.e. by subjecting the substrate to a rotary movement. However, these methods are only applicable to the substrate as a whole, and cannot be used for local treatment of the substrate. Document EP-A-817246 is describing an apparatus and method for wet cleaning or etching of flat substrate surfaces, whereby a substrate is moved through a stationary amount of liquid. This method is also related to a treatment of the substrate as a whole, not of a local zone of said substrate.

Document EP-A-905747 describes a method and apparatus for removing a wet processing liquid from a surface of at least one substrate. According to the method described, a liquid is supplied on a surface of a substrate. Simultaneously, or thereafter, a gaseous tensio-active substance can be supplied, thereby creating a sharply defined liquid-vapour boundary. The substrate is subjected to a rotary movement at a speed to guide said liquid-vapour boundary over said substrate thereby removing said liquid from said substrate.

The method and apparatus described in EP-A-905747 have the purpose of applying and removing a liquid from the whole of the surface of a substrate. The apparatus does not allow a local liquid treatment of a substrate.

During some processing steps, an annular edge area of the substrate is treated, for example for the removal of certain layers, like a resist or a metal film (e.g. Cu). Sometimes, it is only the outer rim of the substrate which is treated, while the top and bottom surfaces of the substrate must remain untouched.

Techniques exist whereby a beam of liquid is directed to the edge area or the rim of a rotating substrate in order to perform these process steps. However these existing techniques offer a poor protection of the substrate surface against the cleaning liquid. It would therefore be advantageous to find a way of protecting the substrate surface while treating said annular edge area or its outer rim with a liquid. Another disadvantage of existing techniques is that the rotational speed of the substrate during processing must be relatively high, which is particularly problematic for large substrates.

Some processing steps require the removal of larger sized features from the substrate surface, e.g. for revealing underlying zero markers, which are used for the accurate lateral positioning during processing, e.g. during photographic exposure. Although the definition of the zero markers themselves requires high accuracy, the accuracy requirements of the window for removing a layer on top of the zero markers can be fairly relaxed. So far in the state of the art, the use of a photo resist step is mostly used to accomplish these areas. By using a photo resist step, a patterned protective resist layer is obtained on the substrate surface. The pattern is such that the areas to be etched are not covered with resist. After this, the substrate is etched and the photo resist layer is removed. This is however an expensive and time-consuming effort.

An alternative way of producing such larger sized areas which are free of film, consists of a local shielding by shielding plates during film deposition. However, this technique leads to an increased risk of particle contamination and scratch formation on the substrate. Furthermore, this shielding technique is not generally applicable. It requires compatibility of the shielding plates with the deposition process of interest. To produce these larger sized features, it would therefore be advantageous to find a method that allows less accuracy but lower cost and higher processing speed, without creating any particle contamination.

Document JP-A-11166862 describes a preconcentration or collection technique, used in contamination measurements for semi-conductors. It is a technique, whereby a droplet is moved over the substrate surface, in order to collect contaminants and subsequently analyze their concentrations. Currently, this technique is mainly used on silicon surfaces, by rendering the surface hydrophobic by way of an HF-treatment. This way, the water-based droplet is contained. The technique is however not confined to silicon surfaces. In some cases, it has been observed that the contact angle between the droplet and the substrate surface is insufficient. Furthermore, it would be advantageous to find a method whereby, in the case of silicon surfaces, the extra processing step of providing an HF-treatment would become unnecessary.

Document US-A-5492566 describes a way of holding a substrate to a flat surface by way of the Bernoulli effect. By supplying a gas at a high speed between said substrate and said surface through an annular nozzle, a pressure drop will result, under said substrate, thus holding said substrate to said surface. Substrates held in this way can be subjected to various wet treatment steps, like cleaning or etching. However, a danger exists of liquid attaching itself to the rim or the backside of the substrate.
In document JP02309638, a wafer etching device is disclosed, wherein a wafer is rotated, etching liquid is jetted out of a nozzle, and at the same time, water or gas is inversely jetted out upward from an inverse jetting-out port to the periphery part of the other surface of the wafer. The inverse gas flow is aimed at preventing the etching liquid to reach the opposite surface. This device is not suitable for treating a part of a flat surface of a substrate. A similar device is disclosed in US5705223, where a central nozzle directs a gas to the backside of a wafer. Again, this device is suitable only for treating a top surface while, protecting a back surface, not for treating part of a top surface, while protecting the rest of that top surface. Document JP11350169 is related to a wet etching apparatus and method, involving a nozzle wherein a gas is jetted out in order to splash a liquid after liquid processing. The gas is thus not used for protecting a part of a substrate surface from contacting a liquid.

### Aim of the invention

The present invention aims to propose a method and apparatus to perform a liquid treatment of a part of a substrate, such as a cleaning or etching step, while another part of said substrate is protected from said liquid by the use of a gaseous substance.

### Summary of the invention

The present invention relates to methods and apparatuses as described in the appended claims. The invention is firstly related to a method according to claim 1.

A first embodiment of the invention is a method comprising the steps of :
- subjecting a circular shaped substrate to a rotational movement, preferably in a horizontal plane, the axis of rotation being perpendicular to the substrate flat surface and comprising the center of said substrate,
- supplying at least one stream of a liquid so that said stream hits a flat surface of said substrate in an area of said surface, said area being adjacent to the outer rim of said substrate,
- simultaneously supplying at least one stream of a gaseous tensio-active substance to the same flat surface so that said stream hits said surface in an area which is adjacent to the area hit by said liquid stream, and closer to the center of rotation.

An additional stream of liquid may be supplied to the opposite surface of said substrate, in order to treat the whole of said opposite surface.

According to another embodiment of the invention, a stream of liquid may be directed at the outer rim of the substrate, while the flat surfaces are protected from said liquid by a stream of a gaseous tensio-active substance.

Another embodiment of the invention is a method comprising the steps of :
- holding a circular shaped substrate,
- supplying a stream of liquid to the whole of an annular edge area of at least one flat surface of said substrate,
- simultaneously supplying a stream of a gaseous tensio-active substance to the central area of said flat surface, said central area comprising the whole of said surface, except said annular area.

In this method, the substrate may be subjected to a rotational movement, the axis of rotation being perpendicular to the substrate's flat surfaces and comprising the center of said substrate.

An additional stream of liquid may be supplied to the whole of a flat surface of said substrate which is lying opposite to a flat surface of which the annular edge area is treated, in order to treat the whole of said opposite flat surface.

Another embodiment of the present invention is a method comprising the steps of :
- holding a circular shaped substrate in a preferably horizontal plane,
- providing a means of bringing an annular edge area of both flat surfaces of said substrate, and the outer rim of said substrate into contact with an amount of liquid,
- supplying streams of a gaseous tensio-active substance to the border areas of said flat surfaces adjacent said amount of liquid.

In this method, the substrate may be equally subjected to a rotational movement, the axis of rotation being perpendicular to the substrate's flat surface and comprising the center of said substrate.

Another embodiment of the present invention is a method comprising the steps of :
- supplying a continuous stream of liquid to a part of a flat surface of a preferably horizontally placed substrate through a first channel,
- draining said stream of liquid from said flat surface through a second channel, concentrically placed around the first channel,
- simultaneously supplying to said flat surface a stream of a gaseous tensio-active substance around said second channel, to prevent said liquid from making contact with the rest of the flat surface of said substrate.

In this embodimemnt, the gaseous tensio-active substance may be drained from the substrate surface through an additional channel.

Another embodiment of the present invention is a method comprising the steps of :
- bringing an amount of liquid into contact with a part of a flat surface of a preferably horizontally placed substrate,
- supplying to said surface a stream of gaseous tensio-active substance around said amount of liquid, thereby preventing said liquid from making contact with the rest of said flat surface.

In this embodiment, the gaseous tensio-active substance may be drained from the substrate surface through an additional channel.

The present invention is also related to an apparatus according to claim 14.

In such an apparatus, a means may be provided for rotating said substrate around an axis which is perpendicular to said substrate's flat surfaces and which comprises the center of said substrate.

According to one embodiment, an apparatus is proposed for treating an annular edge area of at least one flat surface of a circular shaped, preferably horizontally placed substrate, comprising at least one fixed pair of nozzles, a nozzle being defined as an apparatus able to supply a contiguous stream of liquid. Of this pair, one nozzle is arranged to supply a stream of liquid on said annular edge area, while the other nozzle is arranged to dispense a gaseous tensio-active substance on an area of said flat surface adjacent to said annular edge area, and closer to the center of said substrate.

Said pair of nozzles may be positionable on any location along a fixed radius of said substrate. The nozzles may be placed on a movable structure, so that they can be fixed at a variable position along the radius of the substrate.

A nozzle may be arranged to direct a flow of fluid to the flat surface of the substrate which is opposite to a surface of which the edge area is treated, said nozzle being arranged to dispense a stream of liquid on the whole of said opposite flat surface.

According to another embodiment, an apparatus is proposed for treating an annular edge area of a flat surface of a circular shaped substrate, comprising :
- a centrally placed channel arranged to supply a gaseous tensio-active substance to the central part of said flat surface,
- a first annular channel, arranged to supply the liquid to the whole of an annular edge area of said flat surface of said substrate,
- a second annular channel placed concentrically with respect to the first channel and closer to the center of said substrate, said second channel being arranged to guide the gaseous substance coming from the central part of said substrate, in order to prevent said liquid from touching said central part.

Said apparatus may rotate around an axis which is perpendicular to said substrate's flat surfaces and which comprises the center of said substrate.

A nozzle may be arranged to direct a flow of fluid to the flat surface of said substrate which is opposite to a flat surface of which the edge area is treated, said nozzle being arranged to dispense a stream of liquid on the whole of said opposite flat surface.

A sealing device may be added between said substrate and the outer wall of said second annular channel.

According to another embodiment, an apparatus is proposed for treating an annular edge area of both flat surfaces and the outer rim of a circular shaped substrate, placed preferably in a horizontal plane, comprising :
- a container filled with an amount of treatment liquid so that a pressure is maintained above the surface of said amount of liquid, said pressure being less than or equal to the ambient pressure, working on the substrate surface, said container having a narrow gap in one side, into which said circular substrate is partially inserted, so that said edge areas and said outer rim of said substrate are immersed in said liquid,
- at least one pair of nozzles, one nozzle of said pair on each side of said substrate, directing a stream of a gaseous substance at the border area between said container and said substrate.

Said container may rotate around an axis which is perpendicular to said substrate's flat surfaces and which comprises the center of said substrate.

According to another embodiment, an apparatus is proposed for treating a local zone of a preferably horizontally placed substrate, said apparatus comprising :
- a central channel arranged to supply a stream of liquid to the flat surface of said substrate,
- a second channel, concentrically surrounding the first channel, and arranged to drain said stream of liquid from said flat surface of said substrate,
- a third channel, concentrically surrounding the second channel, and arranged to supply a stream of a gaseous tensio-active substance to said flat surface.

According to the same embodiment, a fourth channel may be concentrically placed with respect to said third channel, said fourth channel being arranged to drain said gaseous tensio-active substance from said flat surface.

A sealing device may be added between said substrate and the outer wall of said second channel. In case of a fourth channel, an additional sealing device may be placed between said substrate and the outer wall of said fourth channel.

According to another embodiment, an apparatus is proposed for treating a local zone or for collecting impurities from a flat surface of a preferably horizontally placed substrate, said apparatus comprising :
- a central channel arranged to contain an amount of a liquid in such a way that said liquid is in contact with said flat surface of said substrate, and that a pressure is maintained above said amount of liquid, said pressure being less than or equal to the ambient pressure, working on the substrate surface,
- a second channel, concentrically surrounding the first channel, and arranged to supply a stream of a gaseous tensio-active substance on said flat surface of said substrate.

According to the same embodiment, a third channel may be placed concentrically with respect to said second channel, said third channel being arranged to drain said gaseous tensio-active substance from said flat surface.

A sealing device may be added between said substrate and the outer wall of said central channel. In case of a third channel, an additional sealing device may be placed between the substrate and the outer wall of said third channel.

### Short description of the drawings

Figure 1a (front and top view) describes the method and apparatus according to a first embodiment of the invention, used to clean or etch an edge area of a rotating substrate.

Figure 1b (front view) describes a method and an apparatus for treating the outer rim of a rotating substrate.

Figure 1c (front view) describes the method and an apparatus according to the invention for performing a backside cleaning.

Figure 2 (front and top sectioned view) describes a second method and apparatus according to the invention, used to clean or etch an annular edge area of a substrate.

Figure 3a (sectioned front view and top view) describes a third method and an apparatus according to the invention, used to clean or etch an annular edge area and the outer rim of the substrate.

Figure 3b (sectioned front view and top view) represents an alternative form of the apparatus shown in figure 3a.

Figure 4 (front view) describes a method not falling within the scope of the invention, used to hold a substrate by way of the Bernoulli effect.

Figures 5a and b (front and top sectioned view) describes the method and an apparatus according to the invention, used to clean or etch a local area of a substrate by applying a continuous stream of a liquid.

Figures 6a and b (front and top sectioned view) describes the method and apparatus according to the invention, used to contain a small amount of a liquid on a part of the surface of the substrate.

### Detailed description of the preferred embodiments

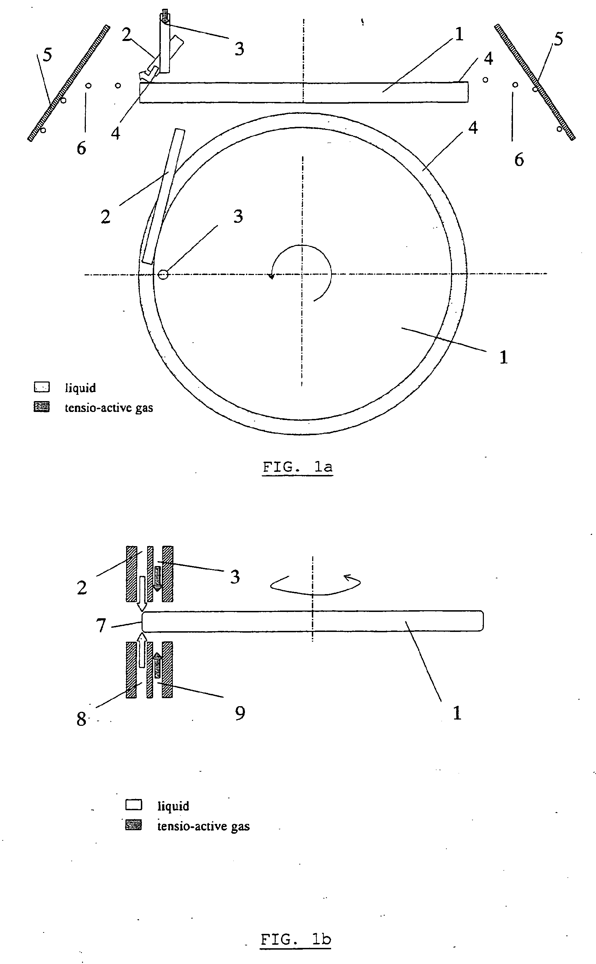

Figure 1a describes the method and apparatus according to a first embodiment of the invention, whereby a liquid, used for cleaning or etching, is supplied on a horizontally placed rotating circular shaped substrate 1 through a first nozzle 2, while a gaseous tensio-active substance is supplied through a second nozzle 3. The rotation of the substrate is indicated by the arrow. The rotation in this and all following embodiments (if a rotation is applied) is occurring around the axis perpendicular to the substrate and comprising the center of said substrate.

In the apparatus of figure 1a, both nozzles are placed such that the streams of liquid and tensio-active substance hit the substrate surface on two spots which are preferably lying along a radius of said substrate. The spot where the liquid stream hits the surface is lying on an annular edge area 4, the spot where the stream of tensio-active gas hits the surface is lying next to the first spot and closer to the center of the substrate. Both nozzles are fixed. The liquid, supplied through nozzle 2 can be used to clean or etch a well defined annular edge area 4 of the surface of the substrate, while the rest of said surface is protected from making contact with the liquid, by the gaseous tensio-active substance. This substance, when mixed with the liquid, reduces the surface tension of said liquid, so that it does not spread out over said surface, but becomes contained and is easily removed from the surface by the centrifugal forces, resulting from the substrate's rotational movement. The walls 5 of the compartment in which the substrate is placed are slanted, so that they can provide an efficient removal of liquid droplets 6, without splashing onto the substrate.

The angles between the nozzles and the substrate surface may differ from the exemplary case of figure 1a. It is especially important for the liquid nozzle to be placed at an angle which minimizes splashing. Both nozzles may be placed on a movable structure, so that they can be fixed at a variable position along the radius of said substrate. Several pairs of nozzles (2,3) may be placed on fixed positions on one or both sides of the substrate.

This embodiment represents an improvement on the state of the art in that it allows the treatment of a localized edge area of the substrate surface, without contacting the central part of said substrate. An additional advantage of the method according to the invention is that it allows a rotational movement of the substrate at a lower speed, compared to existing methods.

If said nozzles are directed at the outer rim 7 of the substrate, as in figure 1b, the method according to the invention is suitable for the treatment of the rim, whereby the surface of the substrate is protected from the liquid. A second pair of nozzles 8 (liquid) and 9 (gaseous tensio-active substance) may be added on the opposite side of the substrate, to improve the efficiency of the rim treatment process.

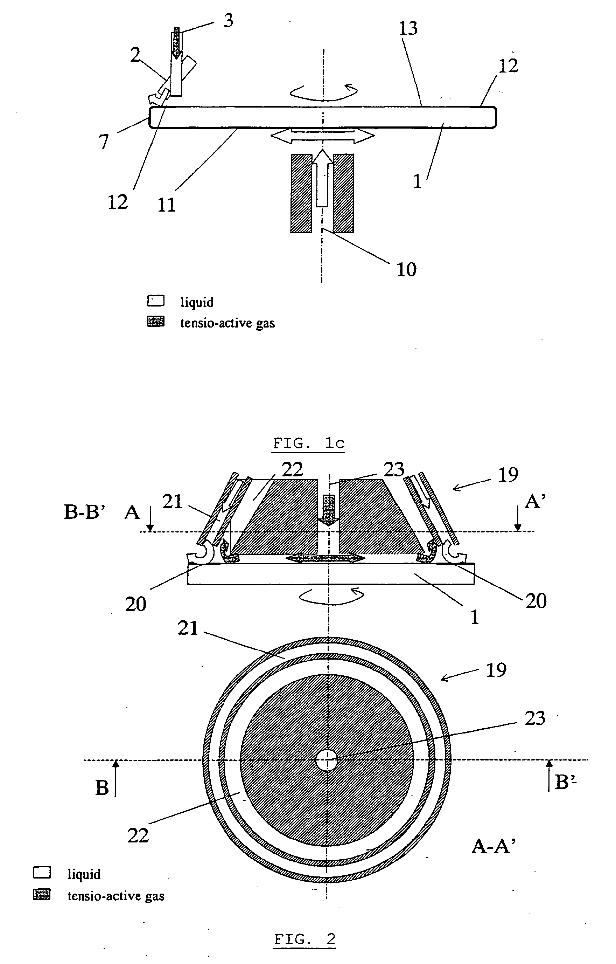

An additional nozzle 10 may be added on the opposite side of the substrate, as is shown in figure 1c. This setup is then suitable for the process of backside cleaning or etching, in which the backside 11 of the substrate is treated as well as a limited area 12 of the front side, and the outer rim 7. Using the method of invention, the central part 13 of the front side of the substrate can be effectively shielded from the treatment liquid.

Figure 2 describes the method and apparatus according to another embodiment of the invention, in which a liquid is dispensed on an annular edge area 20 of a circular shaped substrate 1. The substrate may be stationary or rotating. An apparatus 19 is placed above the surface of the substrate, consisting of two concentric annular channels 21 and 22. Said apparatus may also be rotating around the central perpendicular axis of the substrate. Through the outer channel 21, a liquid is supplied on the edge of the rotating substrate. At the same time a gaseous substance which is tensio-active, is supplied on the central part of the substrate, through a central nozzle 23. The gaseous tensio-active substance is flowing outward from the center of the substrate to the edge, where it is guided through the inner concentric channel 22. Said gaseous substance reduces the surface tension of the liquid in such a way that the liquid is prevented from making contact with the central part of said surface. In case the substrate is rotating, the centrifugal forces acting on the liquid will further facilitate the removal of the liquid from the surface.

This embodiment allows also to treat an edge area of the substrate, presenting the added advantage that the liquid can be applied to the whole of the edge area, which is also protected as a whole by the centrally supplied gaseous tensio-active substance. The same structure may be placed on the opposite side of the substrate, in order to treat both edge areas simultaneously. Also, in case one apparatus 19 is applied, a nozzle may be directed at the opposite side, supplying liquid on said opposite side, analogous to the action of nozzle 10 in figure 1c. The distance between the apparatus 19 and the substrate surface must be sufficiently small, to optimize the separation between the liquid and the gas.

In case both the apparatus 19 and the substrate 1 are stationary or rotating at the same speed, a sealing device, e.g. an O-ring, may be placed between the substrate and the outer wall of channel 22, to separate the central part from the treated edge area.

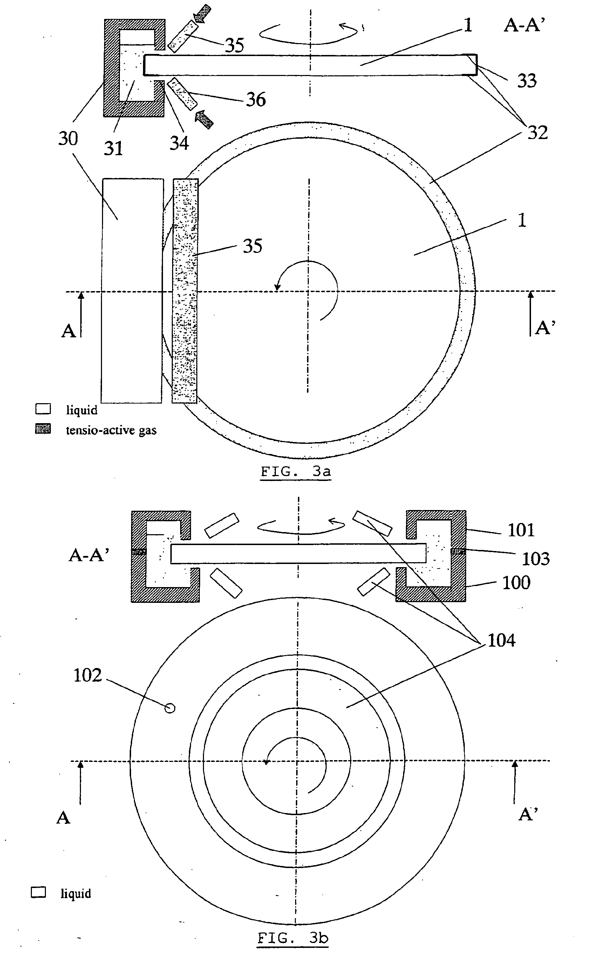

Figure 3a describes the method and apparatus according to another embodiment of the present invention, in which a substrate 1 is subjected to a rotational movement. To one side of the substrate is a container 30, containing a liquid 31, to be used for the treatment of the edge areas 32 and the outer rim 33 of the substrate 1. The gap 34 is made so that it can receive the rotating substrate's edge, with very small clearances. The pressure inside said container 30 is preferably lower than or equal to the pressure outside said container. Nozzles (35, 36) are present on both sides of the substrate, supplying streams of a gaseous substance which is tensio-active, to the border area between the container and the substrate, thereby preventing the liquid from touching the central part of the substrate.

In a derived case of this embodiment, the container may be rotating around the substrate's central perpendicular axis, at the same or a different speed as the substrate. This way, the centrifugal forces will contribute to the efficient separation between the liquid and the central area of the substrate. Also, the substrate may be stationary, while the container is rotating.

The container may even be of an annular form, so that the whole of the edge area to be treated is immersed in the treatment liquid. Also in this case, said annular-shaped container may rotate at a speed, equal to or different from the speed of said substrate. In this case also, the substrate may be stationary. If the container has an annular form, as is shown in figure 3b, it should consist of two parts : a bottom part 100 in which to place the substrate, and a top part 101 which is placed onto the first part, after which the compartment between both parts is filled with a treatment liquid, e.g. via at least one opening 102 so that the substrate's annular edge area is totally immersed in said liquid. Along the outer perimeter of both parts of said container, a suitable sealing device 103 should be provided between said parts so that no treatment liquid can escape from the container. Annular shaped nozzles 104 may be used to supply an equal amount of the gaseous tensio-active substance to the border areas between the container and the substrate.

This embodiment presents the added advantage that the edge areas of both sides and the outer rim of the substrate can be treated simultaneously.

For holding a substrate and subjecting it to a rotational movement in one of the previous embodiments of the present invention, a planetary drive system can be used. In such a system, a set of rotating grooved wheels located around the perimeter of the round substrate, hold and directly drive the substrate. This offers an efficient removal of edge beads. Also, there is a free access to both sides of the substrate. Alternatively, a vacuum chuck may be used to hold the substrate.

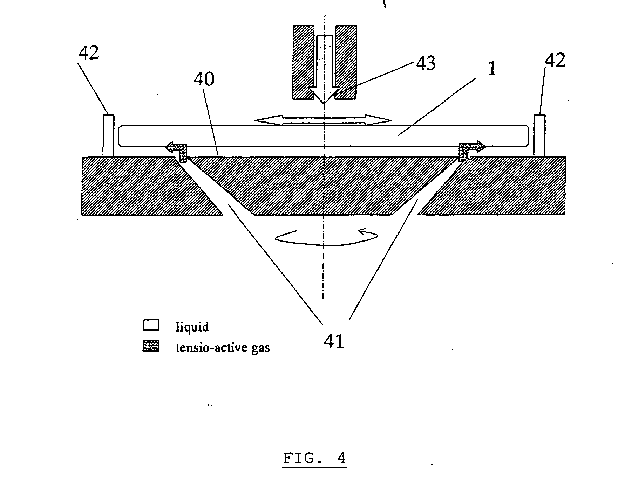

Figure 4 describes a method not falling within the scope of the invention, in which a stream of a gaseous tensio-active substance is used to hold a substrate 1 by way of the Bernoulli effect. The substrate 1 is placed on a flat rotating surface 40 in which an annular nozzle 41 is provided. The rotation of said surface 40 is indicated by the arrow. Through this nozzle, a tensio-active gaseous substance is supplied at a certain speed. This speed is responsible for a pressure drop between the substrate and the flat surface, causing the substrate to be held to said surface. Supports 42 are mounted on the surface 40 to ensure that the substrate is kept in place.

A nozzle 43 is placed on the opposite side to the annular nozzle and is used to supply a stream of treatment liquid. This method is suitable for the process of thinning of the substrate, by applying an etching fluid on one surface, while the opposite surface is effectively protected by the tensio-active gas.

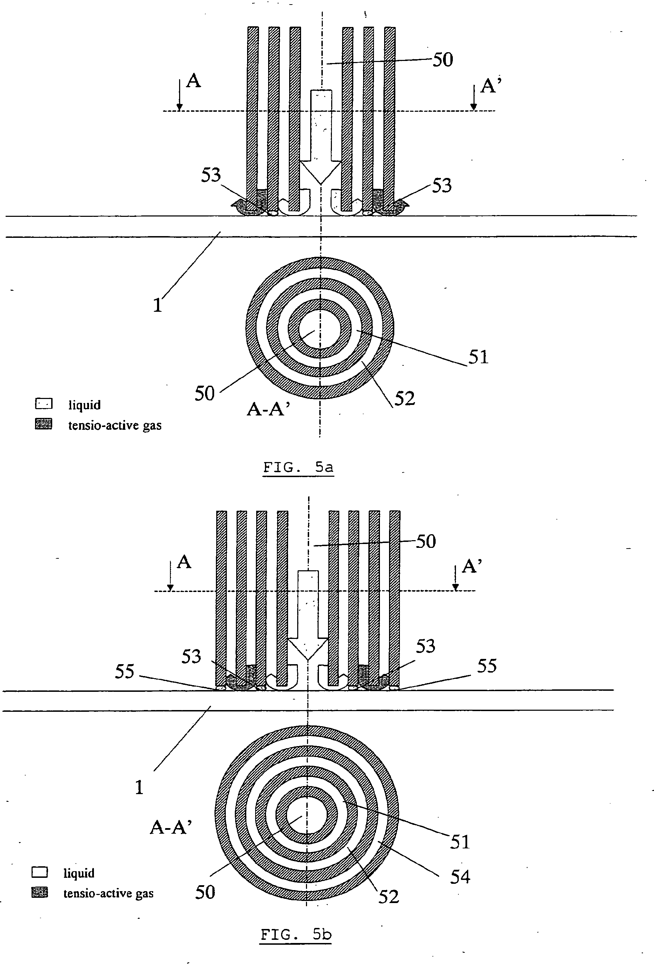

Figure 5a describes the method and apparatus according to another embodiment of the invention, in which a continuous stream of liquid is supplied on the surface of the substrate 1. An apparatus is used, consisting of three concentric channels. The central channel 50 is used to supply the liquid on the surface of the substrate. The surrounding channel 51 is used to drain the liquid from said surface. The third channel 52 is used to supply a gaseous tensio-active substance which reduces the surface tension of the liquid so that it is contained on a localized area of the surface. A sealing device, e.g. an O-ring 53, may be added between the substrate and the outer wall of the liquid draining channel 51. In this case, the stream of gaseous tensio-active substance makes sure that any liquid leaking through the seal is contained on the area to be treated.

Figure 5b reveals an additional fourth channel 54 surrounding channel 52, which may be placed in case the gaseous substance must be prevented from touching the rest of the substrate or from leaking out into the environment. The arrows indicate that the gaseous tensio-active substance is drained from the surface of the substrate through this fourth channel. However, it is equally possible for the gas to be supplied through the fourth channel 54 and drained through the third channel 52.

Whatever the direction of the stream of gaseous tensio-active substance in the apparatus of Figure 5b, an additional sealing device 55 may be placed between the substrate and the outer wall of the apparatus, in order to prevent the gaseous substance from leaking into the environment.

The device containing the three or four channels could be designed so that it covers the area to be treated exactly, or it could be made smaller and subsequently be scanned over the area to be treated.

The device containing the three or four channels may advantageously be placed under a horizontally placed substrate. In this way, a splashing of liquid on the substrate when removing the device may be avoided.

This embodiment can be used to clean local areas of the substrate surface, or to etch these areas, such as zero marker areas, without requiring a photo-resist pattern or shielding plates. For the production of such larger sized film-free areas, this method presents a quicker and cheaper way compared to the classic photo step method. Compared to the method using shielding plates, the method according to the present invention eliminates the danger of particle contamination or scratch formation.

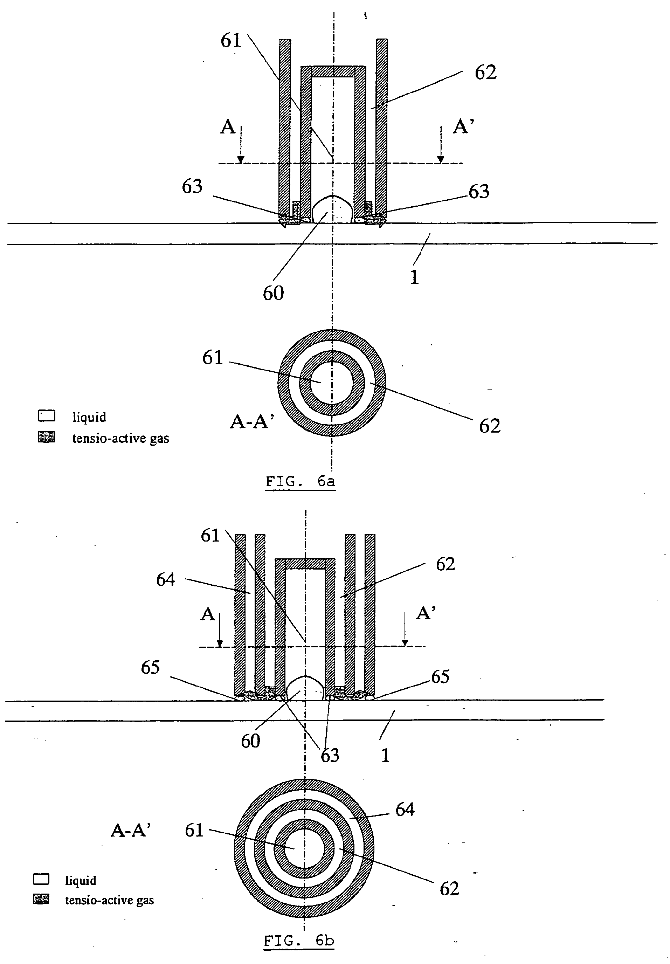

Figure 6a describes the method and apparatus according to another embodiment of the invention, which is suitable for the technique of impurity collection. It may also be suitable for obtaining larger sized film-free areas, like zero-markers. An amount of liquid 60 is put into contact with the surface of the substrate 1 through a central channel 61. This channel is closed off on the top side. Advantageously, the pressure inside the channel 61 is lower than the ambient pressure acting on the substrate surface. The lower the pressure above the liquid, the higher the amount of liquid which can be contained. A channel 62 which is placed around the channel 61 is used to supply a gaseous tensio-active substance, which reduces the surface tension of the liquid so that said liquid is contained on a localized area of the surface.

In case a droplet of said liquid is used, a reduction of the pressure above said droplet is unnecessary. In this case, the central channel 61 may be open on top.

A sealing device such as an O-ring 63 may be added between the substrate and the outer wall of the channel 61. In this case, the stream of gaseous tensio-active substance would make sure that any liquid leaking through the seal is contained on the area to be treated.

In figure 6b, an additional channel 64 is added to the apparatus. This version of the apparatus is preferred when the gaseous tensio-active substance must be prevented from touching the rest of the substrate or from leaking into the environment. The arrows indicate that the gaseous tensio-active substance is drained from the surface of the substrate through this third channel 64. However, it is equally possible for the gas to be supplied through the third channel and drained through the second channel.

Whatever the direction of the stream of gaseous tensio-active substance in the apparatus of Figure 6b, an additional sealing device 65 may advantageously be placed between the substrate and the outer wall of the apparatus, in order to prevent the gaseous substance from leaking into the environment.

This embodiment represents an improvement compared to the existing techniques described in the state of the art, as it is capable of holding an amount of liquid, larger than a droplet, so that a larger amount of contaminants can be collected. In case a droplet is used, the flow of the gaseous tensio-active substance increases the contact angle between the droplet and the surface to be treated. Eventually, it may render the pre-treatment of the substrate surface of hydrophilic substrates unnecessary.

## Claims

1. A method of dispensing liquid on a part of a flat surface of a substrate (1), said substrate having two flat surfaces defining the front and back side of the substrate, while another part of said flat surface is prevented from contacting said liquid by the use of a gaseous substance, said method comprising the steps of :
- supplying a liquid on a part of said flat surface,
- simultaneously with said liquid, supplying a gaseous tensio-active substance to another part of said flat surface adjacent to the part of the flat surface to which said liquid is supplied, said gaseous substance being at least partially miscible with said liquid and when mixed with said liquid yielding a mixture having a surface tension lower than that of said liquid.

2. A method according to claim 1, comprising the steps of :
- subjecting a circular shaped substrate (1) to a rotational movement, preferably in a horizontal plane, the axis of rotation being perpendicular to the substrate flat surface and comprising the center of said substrate,
- supplying at least one stream of a liquid so that said stream hits a flat surface of said substrate in an area (4) of said surface, said area being adjacent to the outer rim of said substrate,
- simultaneously supplying at least one stream of a gaseous tensio-active substance to the same flat surface so that said stream hits said surface in an area which is adjacent to the area (4) hit by said liquid stream, and closer to the center of rotation.

3. A method according to claim 1, comprising the steps of :
- subjecting a circular shaped substrate (1) to a rotational movement, preferably in a horizontal plane, the axis of rotation being perpendicular to the substrate flat surface and comprising the center of said substrate,
- supplying at least one stream of a liquid so that said stream hits the outer rim (7) of said substrate,
- simultaneously supplying at least one stream of a gaseous tensio-active substance to an edge area of a flat surface of said substrate, said area being adjacent to the area of the rim onto which said liquid stream is supplied.

4. A method according to claim 2, wherein an additional stream of liquid is supplied to the whole of a flat surface of said substrate (1) which is lying opposite to a flat surface of which the annular edge area is treated.

5. A method according to claim 1, comprising the steps of :
- holding a circular shaped substrate (1),
- supplying a stream of liquid to the whole of an annular edge area (20) of at least one flat surface of said substrate,
- simultaneously supplying a stream of a gaseous tensio-active substance to the central area of said flat surface, said central area comprising the whole of said surface, except said annular area (20).

6. A method according to claim 5, wherein said substrate is subjected to a rotational movement, the axis of rotation being perpendicular to the substrate's flat surfaces and comprising the center of said substrate.

7. A method according to claim 5, wherein an additional stream of liquid is supplied to the whole of a flat surface of said substrate which is lying opposite to a flat surface of which the annular edge area is treated.

8. A method according to claim 1, comprising the steps of :
- holding a circular shaped substrate (1) in a preferably horizontal plane
- providing a means of bringing an annular edge area (32) of both flat surfaces of said substrate, and the outer rim (33) of said substrate into contact with an amount of liquid (31),
- supplying streams of a gaseous tensio-active substance to the border areas of said flat surfaces adjacent said amount of liquid (31).

9. A method according to claim 8, wherein said substrate is subjected to a rotational movement, the axis of rotation being perpendicular to the substrate's flat surfaces and comprising the center of said substrate.

10. A method according to claim 1, comprising the steps of :
- supplying a continuous stream of liquid to a part of a flat surface of a preferably horizontally placed substrate (1) through a first channel (50),
- draining said stream of liquid from said flat surface through a second channel (51), concentrically placed around the first channel,
- simultaneously supplying to said flat surface a stream of a gaseous tensio-active substance around said second channel, to prevent said liquid from making contact with the rest of the flat surface of said substrate.

11. The method according to claim 10, wherein the gaseous tensio active substance is drained from said substrate through an additional channel (54).

12. A method according to claim 1, comprising the steps of :
- bringing an amount of liquid (60) into contact with a part of a flat surface of a preferably horizontally placed substrate (1),
- supplying to said surface a stream of gaseous tensio-active substance around said amount of liquid, thereby preventing said liquid from making contact with the rest of said flat surface.

13. The method according to claim 12, wherein said gaseous tensio-active substance is drained from the substrate through an additional channel (54).

14. An apparatus for subjecting a substrate (1) having two flat surfaces defining the front and backside of the substrate, to a localized liquid treatment, by dispensing a liquid on a part of a flat surface of the substrate, while another part of said flat surface is prevented from contacting said liquid by supplying a tensio-active gaseous substance to said another part of said flat surface,, wherein said apparatus comprises :
- a means for holding said substrate,
- at least one supply system, able to supply a liquid on a part of a flat surface of said substrate,
- at least one supply system, able to supply a tensio-active gaseous substance to another part of said flat surface, adjacent to the part which is treated by said liquid.

15. An apparatus according to claim 14, wherein a means is provided for rotating said substrate around an axis which is perpendicular to said substrate's flat surfaces and which comprises the center of said substrate.

16. An apparatus according to claim 15 for treating an annular edge area (4) of at least one flat surface of a circular shaped, preferably horizontally placed substrate, said apparatus comprising at least one fixed pair of nozzles (2,3), a nozzle being defined as an apparatus able to supply a contiguous stream of said liquid, said pair comprising one nozzle (2) which is arranged to supply a stream of liquid on said annular edge area, while the other nozzle (3) is arranged to dispense a gaseous tensio-active substance on an area of said flat surface adjacent to said annular edge area, and closer to the center of said substrate.

17. An apparatus according to claim 16, wherein said pair of nozzles is placed on a movable structure, so that they can be fixed at a variable position along the radius of said substrate.

18. An apparatus according to claim 16, wherein a nozzle (10) is arranged to direct a flow of fluid to the flat surface of said substrate (1) which is opposite to a surface of which the edge area is treated, said nozzle being arranged to dispense a stream of a treatment liquid on the whole of said opposite flat surface.

19. An apparatus according to claim 14 or 15 for treating an annular edge area of a flat surface of a circular shaped substrate (1), comprising :
- a centrally placed channel (23) arranged to supply a gaseous tensio-active substance to the central part of said flat surface,
- a first annular channel (21), arranged to supply the liquid to the whole of an annular edge area (20) of said flat surface of said substrate,
- a second annular channel (22) placed concentrically with respect to the first channel and closer to the center of said substrate, said second channel being arranged to guide the gaseous substance coming from the central part of said substrate, in order to prevent said liquid from touching said central part.

20. An apparatus according to claim 19, wherein said apparatus can rotate around an axis which is perpendicular to said substrate's flat surfaces and which comprises the center of said substrate.

21. An apparatus according to claim 19 wherein a nozzle (10) is arranged to direct a flow of fluid to the flat surface of said substrate which is opposite to a flat surface of which the edge area is treated, said nozzle being arranged to dispense a stream of a treatment liquid on the whole of said opposite flat surface.

22. An apparatus according to claim 19, wherein a sealing device is added between said substrate
(1) and the outer wall of said second annular channel (22).

23. An apparatus according to claim 14 or 15, for treating an annular edge area (32) of both flat surfaces and the outer rim (33) of a circular shaped substrate (1), placed preferably in a horizontal plane, comprising :
- a container (30) filled with an amount of treatment liquid (31) so that a pressure is maintained above the surface of said amount of liquid, said pressure being less than or equal to the ambient pressure, working on the substrate surface, said container having a narrow gap (34) in one side, into which said circular substrate is partially inserted, so that said edge areas (32) and said outer rim (33) of said substrate are immersed in said liquid,
- at least one pair of nozzles (35,36), one nozzle of said pair on each side of said substrate, directing a stream of a gaseous substance at the border area between said container (30) and said substrate (1).

24. An apparatus according to claim 23, wherein said container (30) can rotate around an axis which is perpendicular to said substrate's flat surfaces and which comprises the center of said substrate.

25. An apparatus according to claim 14 for treating a local zone of a preferably horizontally placed substrate (1), said apparatus comprising :
- a central channel (50) arranged to supply a stream of liquid to a flat surface of said substrate,
- a second channel (51), concentrically surrounding the first channel, and arranged to drain said stream of liquid from said flat surface of said substrate,
- a third channel (52), concentrically surrounding the second channel (51) and arranged to supply a stream of a tensio-active substance to said flat surface.

26. An apparatus according to claim 25, wherein a fourth channel (54) is concentrically placed with respect to said third channel (52), said fourth channel (54) being arranged to drain said gaseous tensio-active substance from said flat surface.

27. An apparatus according to claim 25, wherein a sealing device (53) is added between said substrate (1) and the outer wall of said second channel (51).

28. An apparatus according to claim 26 wherein sealing devices (53,55) are added between said substrate (1) and the outer wall of said second channel (51) and between said substrate (1) and the outer wall of said fourth channel (54).

29. An apparatus according to claim 14 for treating a local zone or for collecting impurities from a flat surface of a preferably horizontally placed substrate (1), said apparatus comprising :
- a central channel (61) arranged to contain an amount of a liquid (60) in such a way that said liquid is in contact with said flat surface of said substrate, and that a pressure is maintained above said amount of liquid, said pressure being less than or equal to the ambient pressure, working on the substrate surface,
- a second channel (62), concentrically surrounding the first channel (61), and arranged to supply a stream of a gaseous tensio-active substance on said flat surface of said substrate.

30. An apparatus according to claim 29, wherein a third channel (64) is placed concentrically with respect to said second channel (62), said third channel being arranged to drain said gaseous tensio-active substance from said flat surface.

31. An apparatus according to claim 29, wherein a sealing device (63) is added between said substrate (1) and the outer wall of said central channel (61).

32. An apparatus according to claim 30, wherein sealing devices (63,65) are added between said substrate (1) and the outer wall of said central channel (61) and between said substrate (1) and the outer wall of said third channel (64).

## Patentansprüche

1. Verfahren zum Abgeben von Flüssigkeit auf einen Teil einer flachen Oberfläche eines Substrats (1), wobei das Substrat zwei flache Oberflächen aufweist, welche die Vorder- und Rückseite des Substrats definieren, während ein anderer Teil der flachen Oberfläche unter Verwendung einer gasförmigen Substanz daran gehindert wird, mit der Flüssigkeit in Kontakt zu kommen, wobei das Verfahren folgende Schritte umfasst:
- Zuführen einer Flüssigkeit auf einen Teil der flachen Oberfläche,
- gleichzeitig mit der Flüssigkeit Zuführen einer gasförmigen oberflächenspannungsaktiven Substanz zu einem anderen Teil der flachen Oberfläche neben dem Teil der flachen Oberfläche, dem die Flüssigkeit zugeführt wird, wobei die gasförmige Substanz zumindest teilweise mit der Flüssigkeit mischbar ist, und wenn sie mit der Flüssigkeit gemischt wird, eine Mischung ergibt, die eine Oberflächenspannung aufweist, die kleiner ist als die der Flüssigkeit.

2. Verfahren nach Anspruch 1, umfassend folgende Schritte:
- Unterziehen eines kreisförmigen Substrats (1) einer Drehbewegung, bevorzugt in einer waagerechten Ebene, wobei die Drehachse senkrecht zur flachen Substratoberfläche steht und den Mittelpunkt des Substrats umfasst,
- Zuführen zumindest eines Stroms einer Flüssigkeit, so dass der Strom auf eine flache Oberfläche des Substrats in einem Bereich (4) der Oberfläche auftrifft, wobei der Bereich neben dem Außenrand des Substrats liegt,
- gleichzeitiges Zuführen zumindest eines Stroms einer gasförmigen oberflächenspannungsaktiven Substanz zu derselben flachen Oberfläche, so dass der Strom auf die Oberfläche in einem Bereich auftrifft, der sich neben dem Bereich (4), auf den der Flüssigkeitsstrom auftrifft, und näher am Drehmittelpunkt befindet.

3. Verfahren nach Anspruch 1, umfassend folgende Schritte:
- Unterziehen eines kreisförmigen Substrats (1) einer Drehbewegung, bevorzugt in einer waagerechten Ebene, wobei die Drehachse senkrecht zur flachen Substratoberfläche steht und den Mittelpunkt des Substrats umfasst,
- Zuführen zumindest eines Stroms einer Flüssigkeit, so dass der Strom auf den Außenrand (7) des Substrats auftrifft,
- gleichzeitiges Zuführen zumindest eines Stroms einer gasförmigen oberflächenspannungsaktiven Substanz zu einem Randbereich einer flachen Oberfläche des Substrats, wobei der Bereich neben dem Bereich des Randes liegt, dem der Flüssigkeitsstrom zugeführt wird.

4. Verfahren nach Anspruch 2, wobei ein zusätzlicher Flüssigkeitsstrom der Gesamtheit einer flachen Oberfläche des Substrats (1), die sich gegenüber einer flachen Oberfläche befindet, deren ringförmiger Randbereich bearbeitet wird, zugeführt wird.

5. Verfahren nach Anspruch 1, umfassend folgende Schritte:
- Halten eines kreisförmigen Substrats (1),
- Zuführen eines Flüssigkeitsstroms zur Gesamtheit eines ringförmigen Randbereichs (2) zumindest einer flachen Oberfläche des Substrats,
- gleichzeitiges Zuführen eines Stroms einer gasförmigen oberflächenspannungsaktiven Substanz zum mittleren Bereich der flachen Oberfläche, wobei der mittlere Bereich die Gesamtheit der Oberfläche umfasst, mit Ausnahme des ringförmigen Bereichs (20).

6. Verfahren nach Anspruch 5, wobei das Substrat einer Drehbewegung unterzogen wird, wobei die Drehachse senkrecht zu den flachen Oberflächen des Substrats steht und den Mittelpunkt des Substrats umfasst.

7. Verfahren nach Anspruch 5, wobei ein zusätzlicher Flüssigkeitsstrom der Gesamtheit einer flachen Oberfläche des Substrats zugeführt wird, die sich gegenüber einer flachen Oberfläche befindet, deren ringförmiger Randbereich bearbeitet wird.

8. Verfahren nach Anspruch 1, umfassend folgende Schritte:
- Halten eines kreisförmigen Substrats (1) in einer bevorzugt waagerechten Ebene,
- Bereitstellen eines Mittels, um einen ringförmigen Randbereich (32) der beiden flachen Oberflächen des Substrats und den Außenrand (33) des Substrats in Kontakt mit einer Flüssigkeitsmenge (31) zu bringen,
- Zuführen von Strömen einer gasförmigen oberflächenspannungsaktiven Substanz zu den Grenzbereichen der flachen Oberflächen neben der Flüssigkeitsmenge (31).

9. Verfahren nach Anspruch 8, wobei das Substrat einer Drehbewegung unterzogen wird, wobei die Drehachse senkrecht zu den flachen Oberflächen des Substrats steht und den Mittelpunkt des Substrats umfasst.

10. Verfahren nach Anspruch 1, umfassend folgende Schritte:
- Zuführen eines ununterbrochenen Flüssigkeitsstroms zu einem Teil einer flachen Oberfläche eines bevorzugt waagerecht angeordneten Substrats (1) durch einen ersten Kanal (50),
- Entleeren des Flüssigkeitsstroms aus der flachen Oberfläche durch einen zweiten Kanal (51), der konzentrisch um den ersten Kanal angeordnet ist,
- gleichzeitiges Zuführen zur flachen Oberfläche eines Stroms einer gasförmigen oberflächenspannungsaktiven Substanz um den zweiten Kanal herum, um zu verhindern, dass die Flüssigkeit mit dem Rest der flachen Oberfläche des Substrats in Berührung kommt.

11. Verfahren nach Anspruch 10, wobei die gasförmige oberflächenspannungsaktive Substanz aus dem Substrat durch einen zusätzlichen Kanal (54) entleert wird.

12. Verfahren nach Anspruch 1, umfassend folgende Schritte:
- in Kontakt Bringen einer Flüssigkeitsmenge (60) mit einem Teil einer flachen Oberfläche eines bevorzugt waagerecht angeordneten Substrats (1),
- Zuführen zur Oberfläche eines Stroms einer gasförmigen oberflächenspannungsaktiven Substanz um die Flüssigkeitsmenge herum, wodurch vermieden wird, dass die Flüssigkeit mit dem Rest der flachen Oberfläche in Berührung kommt.

13. Verfahren nach Anspruch 12, wobei die gasförmige oberflächenspannungsaktive Substanz aus dem Substrat durch einen zusätzlichen Kanal (64) entleert wird.

14. Einrichtung zum Unterziehen eines Substrats (1) mit zwei flachen Oberflächen, welche die Vorder- und Rückseite des Substrats definieren, einer örtlichen flüssigen Bearbeitung, durch Ausgeben einer Flüssigkeit auf einen Teil einer flachen Oberfläche des Substrats, während ein anderer Teil der flachen Oberfläche daran gehindert wird, mit der Flüssigkeit in Berührung zu kommen, indem dem anderen Teil der flachen Oberfläche eine oberflächenspannungsaktive gasförmige Substanz zugeführt wird, wobei das Einrichtung folgendes umfasst:
- ein Mittel zum Halten des Substrats,
- zumindest ein Zuführungssystem, das eine Flüssigkeit einem Teil einer flachen Oberfläche des Substrats zuführen kann,
- zumindest ein Zuführungssystem, das eine oberflächenspannungsaktive gasförmige Substanz einem anderen Teil der flachen Oberfläche zuführen kann, der neben dem Teil liegt, der durch die Flüssigkeit bearbeitet wird.

15. Einrichtung nach Anspruch 14, wobei ein Mittel bereitgestellt wird zum Drehen des Substrats um eine Achse, die zu den flachen Oberflächen des Substrats senkrecht steht, und die den Mittelpunkt des Substrats umfasst.

16. Einrichtung nach Anspruch 15 zum Bearbeiten eines ringförmigen Randbereichs (4) zumindest einer flachen Oberfläche eines kreisförmigen, bevorzugt waagerecht angeordneten Substrats, wobei das Einrichtung zumindest ein feststehendes Düsenpaar (2, 3) umfasst, wobei eine Düse als eine Einrichtung definiert ist, die einen benachbarten Strom mit Flüssigkeit versorgen kann, wobei das Paar eine Düse (2) umfasst, die angeordnet ist, um einen Flüssigkeitsstrom auf dem ringförmigen Randbereich zu versorgen, während die andere Düse (3) angeordnet ist, um eine gasförmige oberflächenspannungsaktive Substanz auf einem Bereich der flachen Oberfläche neben dem ringförmigen Randbereich und näher am Mittelpunkt des Substrats abzugeben.

17. Einrichtung nach Anspruch 16, wobei das Düsenpaar auf einer bewegbaren Struktur angeordnet ist, so dass es in einer verstellbaren Position am Radius des Substrats entlang befestigt werden kann.

18. Einrichtung nach Anspruch 16, wobei eine Düse (10) angeordnet ist, um einen Flüssigkeitsfluss auf die flache Oberfläche des Substrats (1) zu richten, das sich gegenüber einer Oberfläche befindet, deren Randbereich bearbeitet wird, wobei die Düse angeordnet ist, um einen Strom einer Bearbeitungsflüssigkeit auf die Gesamtheit der gegenüberliegenden flachen Oberfläche abzugeben.

19. Einrichtung nach Anspruch 14 oder 15 zur Bearbeitung eines ringförmigen Randbereichs einer flachen Oberfläche eines kreisförmigen Substrats (1), umfassend:
- einen zentral angeordneten Kanal (23), der angeordnet ist, um dem mittleren Teil der flachen Oberfläche eine gasförmige oberflächenspannungsaktive Substanz zuzuführen,
- einen ersten ringförmigen Kanal (21), der angeordnet ist, um die Flüssigkeit der Gesamtheit eines ringförmigen Randbereichs (20) der flachen Oberfläche des Substrats zuzuführen,
- einen zweiten ringförmigen Kanal (22), der im Verhältnis zu dem ersten Kanal konzentrisch und näher zum Mittelpunkt des Substrats angeordnet ist, wobei der zweite Kanal angeordnet ist, um die gasförmige Substanz zu leiten, die aus dem mittleren Teil des Substrats kommt, um zu verhindern, dass die Flüssigkeit mit dem mittleren Teil in Berührung kommt.

20. Einrichtung nach Anspruch 19, wobei die Einrichtung sich um eine Achse drehen kann, die zu den flachen Oberflächen des Substrats senkrecht steht und die den Mittelpunkt des Substrats umfasst.

21. Einrichtung nach Anspruch 19, wobei eine Düse (10) angeordnet ist, um einen Flüssigkeitsfluss auf die flache Oberfläche des Substrats zu richten, die sich gegenüber einer flachen Oberfläche befindet, deren Randbereich bearbeitet wird, wobei die Einrichtung angeordnet ist, um einen Strom einer Bearbeitungsflüssigkeit auf der Gesamtheit der gegenüberliegenden flachen Oberfläche abzugeben.

22. Einrichtung nach Anspruch 19, wobei eine Abdichtungsvorrichtung zwischen dem Substrat (1) und der Außenwand des zweiten ringförmigen Kanals (22) hinzugefügt wird.

23. Einrichtung nach Anspruch 14 oder 15 zum Bearbeiten eines ringförmigen Randbereichs (32) der beiden flachen Oberflächen und des Außenrands (33) eines kreisförmigen Substrats (1), das bevorzugt in einer waagerechten Ebene angeordnet ist, umfassend:
- einen Behälter (30), der mit einer Menge von Bearbeitungsflüssigkeit (31) gefüllt ist, so dass ein Druck oberhalb der Oberfläche der Flüssigkeitsmenge aufrechterhalten wird, wobei der Druck weniger oder gleich dem Umgebungsdruck ist, der auf die Substratoberfläche einwirkt, wobei der Behälter in einer Seite über einen engen Spalt (34) verfügt, in den das kreisförmige Substrat teilweise eingefügt wird, so dass die Randbereiche (32) und der Außenrand (33) des Substrats in die Flüssigkeit eingetaucht werden,
- zumindest ein Paar Düsen (35, 36), mit einer Düse des Paars auf jeder Seite des Substrats, die einen Strom einer gasförmigen Substanz am Grenzbereich zwischen dem Behälter (30) und dem Substrat (1) leiten.

24. Einrichtung nach Anspruch 23, wobei der Behälter (30) sich um eine Achse drehen kann, die zu den flachen Oberflächen des Substrats senkrecht steht und die den Mittelpunkt des Substrats umfasst.

25. Einrichtung nach Anspruch 14 zur Bearbeitung einer lokalen Zone eines bevorzugt waagerecht angeordneten Substrats (1), wobei die Einrichtung folgendes umfasst:
- einen mittleren Kanal (50), der angeordnet ist, um einer flachen Oberfläche des Substrats einen Flüssigkeitsstrom zuzuführen,
- einen zweiten Kanal (51), der den ersten Kanal konzentrisch umgibt und angeordnet ist, um den Flüssigkeitsstrom von der flachen Oberfläche des Substrats zu entleeren,
- einen dritten Kanal (52), der konzentrisch den zweiten Kanal (51) umgibt und angeordnet ist, um der flachen Oberfläche einen Strom einer oberflächenspannungsaktiven Substanz zu zuführen.

26. Einrichtung nach Anspruch 25, wobei ein vierter Kanal (54) im Verhältnis zum dritten Kanal (52) konzentrisch angeordnet ist, wobei der vierte Kanal (54) angeordnet ist, um die gasförmige oberflächenspannungsaktive Substanz aus der flachen Oberfläche zu entleeren.

27. Einrichtung nach Anspruch 25, wobei eine Abdichtungsvorrichtung (53) zwischen dem Substrat (1) und der Außenwand des zweiten Kanals (51) hinzugefügt wird.

28. Einrichtung nach Anspruch 26, wobei die Abdichtungsvorrichtungen (53, 55) zwischen dem Substrat (1) und der Außenwand des zweiten Kanals (51) und zwischen dem Substrat (1) und der Außenwand des vierten Kanals (54) hinzugefügt werden.

29. Einrichtung nach Anspruch 14 zur Bearbeitung einer lokalen Zone oder zum Sammeln von Verunreinigungen von einer flachen Oberfläche eines bevorzugt waagerecht angeordneten Substrats (1), wobei die Einrichtung folgendes umfasst:
- einen mittleren Kanal (61), der angeordnet ist, um eine Menge einer Flüssigkeit (60) derart zu enthalten, dass die Flüssigkeit mit der flachen Oberfläche des Substrats in Berührung steht, und dass ein Druck oberhalb der Flüssigkeitsmenge aufrechterhalten wird, wobei der Druck kleiner oder gleich dem Umgebungsdruck ist, der auf die Substratoberfläche einwirkt,
- einen zweiten Kanal (62), der den ersten Kanal (61) konzentrisch umgibt, und angeordnet ist, um einen Strom einer gasförmigen oberflächenspannungsaktiven Substanz auf der flachen Oberfläche des Substrats zuzuführen.

30. Einrichtung nach Anspruch 29, wobei ein dritter Kanal (64) im Verhältnis zu dem zweiten Kanal (62) konzentrisch angeordnet ist, wobei der dritte Kanal angeordnet ist, um die gasförmige oberflächenspannungsaktive Substanz aus der flachen Oberfläche zu entleeren.

31. Einrichtung nach Anspruch 29, wobei eine Abdichtungsvorrichtung (63) zwischen dem Substrat (1) und der Außenwand des mittleren Kanals (61) hinzugefügt wird.

32. Einrichtung nach Anspruch 30, wobei die Abdichtungsvorrichtungen (63, 65) zwischen dem Substrat (1) und der Außenwand des mittleren Kanals (61) und zwischen dem Substrat (1) und der Außenwand des dritten Kanals (64) hinzugefügt werden.

## Revendications

1. Procédé de distribution de liquide sur une partie d'une surface plate d'un substrat (1), ledit substrat présentant deux surfaces plates définissant le côté avant et arrière du substrat, alors qu'une autre partie de ladite surface plate est empêchée d'entrer en contact avec ledit liquide par l'utilisation d'une substance gazeuse, ledit procédé comprenant les étapes consistant à :
- fournir un liquide sur une partie de ladite surface plate,
- simultanément avec ledit liquide, fournir une substance tensioactive gazeuse à une autre partie de ladite surface plate à côté de la partie de la surface plate à laquelle ledit liquide est fourni, ladite substance gazeuse étant au moins en partie miscible avec ledit liquide, et lorsqu'elle mélangée avec ledit liquide, produisant un mélange ayant une tension de surface inférieure à celle dudit liquide.

2. Procédé selon la revendication 1, comprenant les étapes consistant à :
- soumettre un substrat de forme circulaire (1) à un mouvement rotatif, de préférence dans un plan horizontal, l'axe de rotation étant perpendiculaire à la surface plate de substrat et comprenant le centre dudit substrat,
- fournir au moins un courant d'un liquide de sorte que ledit courant atteint une surface plate dudit substrat dans une zone (4) de ladite surface, ladite zone étant adjacente au bord extérieur dudit substrat,
- simultanément, fournir au moins un courant d'une substance tensioactive gazeuse à la même surface plate de sorte que ledit courant atteint ladite surface dans une zone qui est adjacente à la zone (4) atteinte par ledit courant de liquide, et plus proche du centre de rotation.

3. Procédé selon la revendication 1, comprenant les étapes consistant à :
- soumettre un substrat de forme circulaire (1) à un mouvement rotatif, de préférence dans un plan horizontal, l'axe de rotation étant perpendiculaire à la surface plate de substrat et comprenant le centre dudit substrat,
- fournir au moins un courant d'un liquide de sorte que ledit courant atteint le bord extérieur (7) dudit substrat,
- simultanément, fournir au moins un courant d'une substance tensioactive gazeuse à une zone de bord d'une surface plate dudit substrat, ladite zone étant adjacente à la zone du bord sur laquelle ledit courant liquide est fourni.

4. Procédé selon la revendication 2, dans lequel un courant supplémentaire de liquide est fourni à l'ensemble d'une surface plate dudit substrat
(1) qui se trouve à l'opposé d'une surface plate dont la zone de bord annulaire est traitée.

5. Procédé selon la revendication 1, comprenant les étapes consistant à :
- tenir un substrat de forme circulaire (1),
- fournir un courant de liquide à l'ensemble d'une zone de bord annulaire (20) d'au moins une surface plate dudit substrat,
- simultanément, fournir un courant d'une substance tensioactive gazeuse à la zone centrale de ladite surface plate, ladite surface centrale comprenant l'ensemble de ladite surface, excepté ladite zone annulaire (20).

6. Procédé selon la revendication 5, dans lequel ledit substrat est soumis à un mouvement rotatif, l'axe de rotation étant perpendiculaire aux surfaces plates du substrat et comprenant le centre dudit substrat.

7. Procédé selon la revendication 5, dans lequel un courant supplémentaire de liquide est fourni à l'ensemble d'une surface plate dudit substrat qui se trouve à l'opposé d'une surface plate dont la zone de bord annulaire est traitée.

8. Procédé selon la revendication 1, comprenant les étapes consistant à :
- tenir un substrat de forme circulaire (1) dans un plan de préférence horizontal,
- prévoir un moyen pour amener une zone de bord annulaire (32) des deux surfaces plates dudit substrat et le bord extérieur (33) dudit substrat en contact avec une quantité de liquide (31),
- fournir des courants d'une substance tensioactive gazeuse aux zones de limite desdites surfaces plates à côté de ladite quantité de liquide (31).

9. Procédé selon la revendication 8, dans lequel ledit substrat est soumis à un mouvement rotatif, l'axe de rotation étant perpendiculaire aux surfaces plates du substrat et comprenant le centre dudit substrat.

10. Procédé selon la revendication 1, comprenant les étapes consistant à :
- fournir un courant continu de liquide à une partie d'une surface plate d'un substrat (1) placé de préférence horizontalement à travers un premier canal (50),
- drainer ledit courant de liquide de ladite surface plate à travers un deuxième canal (51), placé de façon concentrique autour du premier canal,
- simultanément, fournir à ladite surface plate un courant d'une substance tensioactive gazeuse autour dudit deuxième canal, pour empêcher ledit liquide d'entrer en contact avec le reste de la surface plate dudit substrat plat.

11. Procédé selon la revendication 10, dans lequel la substance tensioactive gazeuse est drainée à partir dudit substrat à travers un canal supplémentaire (54).

12. Procédé selon la revendication 1, comprenant les étapes consistant à :
- amener une quantité de liquide (60) en contact avec une partie d'une surface plate d'un substrat (1) placé de préférence horizontalement,
- fournir à ladite surface un courant d'une substance tensioactive gazeuse autour de ladite quantité de liquide, empêchant ainsi ledit liquide d'entrer en contact avec le reste de ladite surface plate.

13. Procédé selon la revendication 12, dans lequel ladite substance tensioactive gazeuse est drainée du substrat à travers un canal supplémentaire (64).

14. Equipement pour soumettre un substrat (1) présentant deux surfaces plates définissant l'avant et l'arrière du substrat à un traitement liquide localisé, en distribuant un liquide sur une partie d'une surface plate du substrat, alors qu'une autre partie de ladite surface plate est empêchée d'entrer en contact avec ledit liquide par la fourniture d'une substance gazeuse tensioactive à ladite autre partie de ladite surface plate, dans laquelle ledit équipement comprend :
- un moyen pour tenir ledit substrat,
- au moins un système de fourniture, capable de fournir un liquide sur une partie d'une surface plate dudit substrat,
- au moins un système de fourniture, capable de fournir une substance gazeuse tensioactive à une autre partie de ladite surface plate, à côté de la partie qui est traitée par ledit liquide.

15. Equipement selon la revendication 14, dans lequel un moyen sont prévus pour faire tourner ledit substrat autour d'un axe qui est perpendiculaire aux surfaces plates dudit substrat et qui comprend le centre dudit substrat.

16. Equipement selon la revendication 15 pour traiter une zone de bord annulaire (4) d'au moins une surface plate d'un substrat de forme circulaire, placé de préférence horizontalement, ledit équipement comprenant au moins une paire fixe de buses (2, 3), une buse étant définie comme un équipement capable de fournir un courant contigu dudit liquide, ladite paire comprenant une buse (2) qui est agencée pour fournir un courant de liquide sur ladite zone de bord annulaire, alors que l'autre buse (3) est agencée pour distribuer une substance tensioactive gazeuse sur une zone de ladite surface plate adjacente à ladite zone de bord annulaire, et plus proche du centre dudit substrat.

17. Equipement selon la revendication 16, dans lequel ladite paire de buses est placée sur une structure mobile de sorte qu'elles peuvent être fixées dans une position variable le long du rayon dudit substrat.

18. Equipement selon la revendication 16, dans lequel une buse (10) est agencée pour diriger un flux de fluide vers la surface plate dudit substrat (1) qui est opposée à une surface dont la zone de bord est traitée, ladite buse étant agencée pour distribuer un courant d'un liquide de traitement sur l'ensemble de ladite surface plate opposée.

19. Equipement selon la revendication 14 ou 15 pour traiter une zone de bord annulaire d'une surface plate d'un substrat de forme circulaire (1), comprenant :
- un canal (23) placé de façon centrale, agencé pour fournir une substance tensioactive gazeuse à la partie centrale de ladite surface plate,
- un premier canal annulaire (21), agencé pour fournir le liquide à l'ensemble d'une zone de bord annulaire (20) de ladite surface plate dudit substrat,
- un deuxième canal annulaire (22) placé de façon concentrique par rapport au premier canal et plus proche du centre dudit substrat, ledit deuxième canal étant agencé pour guider la substance gazeuse provenant de la partie centrale dudit substrat, afin d'empêcher ledit liquide de toucher ladite partie centrale.

20. Equipement selon la revendication 19, dans lequel ledit équipement peut tourner autour d'un axe qui est perpendiculaire aux surfaces plates dudit substrat et qui comprend le centre dudit substrat.

21. Equipement selon la revendication 19, dans lequel une buse (10) est agencée pour diriger un flux de fluide vers la surface plate dudit substrat qui est opposée à une surface plate dont la zone de bord est traitée, ladite buse étant agencée pour distribuer un courant d'un liquide de traitement sur l'ensemble de ladite surface plate opposée.

22. Equipement selon la revendication 19, dans lequel un dispositif d'étanchéité est ajouté entre ledit substrat (1) et la paroi extérieure dudit deuxième canal annulaire (22).

23. Equipement selon la revendication 14 ou 15, pour traiter une zone de bord annulaire (32) des deux surfaces plates et du bord extérieur (33) d'un substrat de forme circulaire (1), de préférence placé dans un plan horizontal, comprenant :
- un conteneur (30) rempli d'une quantité d'un liquide de traitement (31) de sorte qu'une pression est maintenue au-dessus de la surface de ladite quantité de liquide, ladite pression étant inférieure ou égale à la pression ambiante, agissant sur la surface de substrat, ledit conteneur présentant un entrefer étroit (34) dans un côté, dans lequel ledit substrat circulaire est inséré en partie, de sorte que lesdites zones de bord (32) et ledit bord extérieur (33) dudit substrat sont immergés dans ledit liquide,
- au moins une paire de buses (35, 36), une buse de ladite paire de chaque côté dudit substrat, dirigeant un courant d'une substance gazeuse au niveau de la zone de limite entre ledit conteneur (30) et ledit substrat (1).

24. Equipement selon la revendication 23, dans lequel ledit conteneur (30) peut tourner autour d'un axe qui est perpendiculaire aux surfaces plates dudit substrat et qui comprend le centre dudit substrat.

25. Equipement selon la revendication 14 pour traiter une zone locale d'un substrat (1) placé de préférence horizontalement, ledit équipement comprenant :
- un canal central (50) agencé pour fournir un courant de liquide à une surface plate dudit substrat,
- un deuxième canal (51), entourant de façon concentrique le premier canal, et agencé pour drainer ledit courant de liquide de ladite surface plate dudit substrat,
- un troisième canal (52), entourant de façon concentrique le deuxième canal (51) et agencé pour fournir un courant d'une substance tensioactive à ladite surface plate.

26. Equipement selon la revendication 25, dans lequel un quatrième canal (54) est placé de façon concentrique par rapport audit troisième canal (52), ledit quatrième canal (54) étant agencé pour drainer ladite substance tensioactive gazeuse de ladite surface plate.

27. Equipement selon la revendication 25, dans lequel un dispositif d'étanchéité (53) est ajouté entre ledit substrat (1) et la paroi extérieure dudit deuxième canal (51).

28. Equipement selon la revendication 26, dans lequel des dispositifs d'étanchéité (53, 55) sont ajoutés entre ledit substrat (1) et la paroi extérieure dudit deuxième canal (51) et entre ledit substrat (1) et la paroi extérieure dudit quatrième canal (54).

29. Equipement selon la revendication 14 pour traiter une zone locale ou pour collecter des impuretés d'une surface plate d'un substrat (1) placé de préférence horizontalement, ledit équipement comprenant :
- un canal central (61) agencé pour contenir une quantité d'un liquide (60) de telle sorte que ledit liquide est en contact avec ladite surface plate dudit substrat, et qu'une pression est maintenue au-dessus de ladite quantité de liquide, ladite pression étant inférieure ou égale à la pression ambiante, agissant sur la surface de substrat,
- un deuxième canal (62), entourant de façon concentrique le premier canal (61), et agencé pour fournir un courant d'une substance tensioactive gazeuse sur ladite surface plate dudit substrat.

30. Equipement selon la revendication 29, dans lequel un troisième canal (64) est placé de façon concentrique par rapport audit deuxième canal (62), ledit troisième canal étant agencé pour drainer ladite substance tensioactive gazeuse de ladite surface plate.

31. Equipement selon la revendication 29, dans lequel un dispositif d'étanchéité (63) est ajouté entre ledit substrat (1) et la paroi extérieure dudit canal central (61).

32. Equipement selon la revendication 30, dans lequel des dispositifs d'étanchéité (63, 65) sont ajoutés entre ledit substrat (1) et la paroi extérieure dudit canal central (61) et entre ledit substrat (1) et la paroi extérieure dudit troisième canal (64).
